Europäisches Patentamt

European Patent Office

Office européen des brevets

(11) Publication number: **0 124 358**
**B1**

## EUROPEAN PATENT SPECIFICATION

(45) Date of publication of patent specification: **14.02.90**

(51) Int. Cl.⁵: **H 01 L 23/52,** H 01 L 21/90

(21) Application number: **84302827.5**

(22) Date of filing: **26.04.84**

(54) Method for disconnecting interconnection using focused ion beam.

(30) Priority: **30.04.83 JP 76442/83**

(43) Date of publication of application:
**07.11.84 Bulletin 84/45**

(45) Publication of the grant of the patent:
**14.02.90 Bulletin 90/07**

(84) Designated Contracting States:
**DE FR GB**

(56) References cited:
**EP-A-0 082 639**
**DE-A-2 651 187**

**IEDM TECHNICAL DIGEST - INTERNATIONAL ELECTRON DEVICES MEETING, San Francisco, 13th-15th December 1982, pages 572-575, IEEE, New York, US; K.HASHIMOTO et al.: "Electron-beam fuse programming for redundancy technology"**

(73) Proprietor: **KABUSHIKI KAISHA TOSHIBA 72, Horikawa-cho Saiwai-ku Kawasaki-shi Kanagawa-ken 210 (JP)**

(72) Inventor: **Takigawa, Tadahiro c/o Patent Division Kabushiki Kaisha Toshiba 1-1 Shibaura 1-chome Minato-ku Tokyo 105 (JP)**

(74) Representative: **Freed, Arthur Woolf et al MARKS & CLERK 57-60 Lincoln's Inn Fields London WC2A 3LS (GB)**

(56) References cited:
**IDEM**
**APPLIED PHYSICS LETTERS, vol. 34, no. 5, 1st March 1979, pages 310-312, American Institute of Physics, New York, US; R.L.SELIGER et al.: "A high-intensity scanning ion probe with submicrometer spot size"**
**JOURNAL OF VACUUM SCIENCE AND TECHNOLOGY, vol. 16, no. 6, November/December 1979, pages 1610-1612, American Vacuum Society; R.L.SELIGER et al.: "High-resolution, ion-beam processes for microstructure fabrication"**

Courier Press, Leamington Spa, England.

## EP 0 124 358 B1

(56) References cited:

**JAPANESE JOURNAL OF APPLIED PHYSICS, vol. 21, no. 12, part 2, December 1982, pages L792-L794, Tokyo, JP; KENJI GAMO et al.: "Ion beam assisted maskless etching of GaAs by 50 keV focused ion beam"**

**THIN SOLID FILMS, vol. 92, no. 1/2, June 1982, pages 165-169, Elsevier Sequoia, Lausanne, CH; R.L.KUBENA et al.: "High resolution sputtering using a focused ion beam"**

## Description

The present invention relates to a method of disconnecting an interconnection on a semiconductor wafer using a finely focused ion beam.

Recently, high-density version of LSIs has been rapidly progressed, and a 1-Mbyte MOS memory has been fabricated. In addition, a large-chip LSI will be developed which has a CPU, a memory, and other functions.

On the other hand, when the degree of density of LSIs advances and the area of a chip increases, the yield of the chip rapidly deteriorates due to defects and this is uneconomical. To solve this problem, redundancy technology has been adopted. This redundancy technology is such that a redundancy circuit is incorporated in a semiconductor device, and a partially defective portion of the chip is switched to this redundancy circuit to compensate the defect. This technology is indispensable in producing large-chip LSIs. When describing, by way of example, a semiconductor memory, a redundancy circuit with a spare memory is formed when a semiconductor device is manufactured. In the case where an inferior bit is found at the time of examining the semiconductor device, the inferior bit is switched to the spare memory in the redundancy circuit.

To make the redundancy circuit operative, it is necessary to incorporate a fuse (interconnection) in the semiconductor device and to disconnect this fuse. Although a current disconnecting method and a laser disconnecting method have been conventionally used to disconnect the fuse, these methods have the following problems. That is, according to the current disconnecting method, since a fusing current of 50 to 100 [mA] is required, an additional circuit is required, and this makes a heavy burden for its design. Furthermore, the number of processes for producing the semiconductor device increases. The damage region, which the semiconductor device will be subjected to when the fuse is melted, is wide. A high degree of working accuracy is required to manufacture the redundancy circuit. On the other hand, according to the laser disconnecting method, the minimum region where the disconnection is possible is $10 \times 10$ [$\mu m^2$], and this is narrower than that of the current disconnecting method; however, it is several times larger compared with the device's dimensions. Due to this, the damage region cannot be eliminated. Therefore, at present, only a few portions per chip can be switched. Furthermore, although the laser beam is absorbed by silicon, the laser beam is reflected from aluminum, which is frequently used as interconnections. For this reason, using the laser beam to disconnect a certain kind of metal is not preferred.

Therefore, recently, a method of disconnecting the fuse using an electron beam has been proposed. For example, this method is disclosed in, K. Hashimoto et al., "Electron-Beam Fuse Programming for Redundancy Technology", IEDM Technical Digest, pages 572—575, 1982. With this method, it is possible to disconnect the fuse with a beam thinner than the laser beam, thereby enabling the region irradiated by the beam to be extremely small. In addition, since a high electrical power density can be concentrated, the time necessary for disconnection can be remarkably shortened.

However, according to the method using the electron beam mentioned above, there is a disadvantage in that, for example, the threshold voltage of an MOS transistor will vary due to radiation damage. Furthermore, in the case where a semiconductor element is covered by a passivation film, the passivation film is charged up and thus it becomes difficult to detect the location by secondary electrons, causing an inconvenience such that the electron-beam irradiating position deviates. Therefore, it is improper for fine working of the device. In addition, in the case where, in order to eliminate the occurrence of electrically charging the passivation film a hole is preliminarily formed in the peripheral portion of the fuse and thereafter the electron beam is irradiated to melt the fuse, the passivation step has to be further performed after fusing. Also, it is fairly difficult to set an electron beam's diameter to 0.5 $\mu m$ or less due to the proximity effect between electrons. Therefore, damages are still caused over a fairly wide range at the time of processing.

There is known an example of using an ion beam in the field of lithography. However, it is difficult to obtain an ion beam with high energy due to the interaction between ions. Consequently, it takes some ten thousand hours to produce a one-chip LSI device.

The Journal of Vacuum Science and Technology, Vol. 16, No. 6, November/December 1979, pps. 1610—1612 (RL Seliger et al) relates to "High-resolution ion-beam processes for microstructure fabrication". More particularly, this reference relates to focused ion-beams which are employed in micro-circuit fabrication, that is for maskless ion implantation and high resolution lithographic processes.

An article entitled "High-resolution sputtering using a focus ion beam" published in Thin Solid Films, Vol. 92, No. 1/2, June 1982, pps. 165—169 (PL Kubina et al) relates to High resolution sputter etching of $SiO_2$. Si and GaAs wafers and submicron machining of gold films.

It is an object of the present invention to provide an improved method of disconnecting an interconnection using a focused ion beam.

It is another object of the invention to provide an interconnection disconnecting method which can easily disconnect a desired interconnection without exerting radiation damage to a device.

It is a further object of the invention to provide an interconnection disconnecting method which can contribute to improving the yield of semiconductor chips.

To attain the above objects, a method of disconnecting an interconnection using a focused ion beam according to the present invention comprises the steps of:

(A) aligning a portion to be disconnected of an interconnection formed on a semiconductor substrate to connect semiconductor elements formed in the substrate with an ion beam irradiating location, by irradiating the focused ion beam onto an insulating film provided over the semiconductor substrate and the interconnection and determining a location of the portion of the interconnection;

(B) irradiating a focused ion beam generated from a focused ion beam source onto the insulating film and the portion of the interconnection to etch the insulating film and the portion of interconnection by sputtering, thereby disconnecting the interconnection.

As mentioned above, according to the method of disconnecting an interconnection using a focused ion beam, the following advantages result.

(c1) Since the interconnection is disconnected by the etching due to the sputtering or bombardment, this makes the disconnection possible for the region which is substantially equal to an ion beam diameter. Since the ion beam diameter can be set to approximately 0.1 µm, it is possible to disconnect a region of a diameter of 0.1 µm, in principle. In the case of using an electron beam, it is difficult to set the beam diameter to 0.5 µm or less due to the proximity effect between electrons.

(c2) Different from the disconnecting method using an electron beam, even if a focused ion beam is used to detect a positioning mark or to disconnect an interconnection, a semiconductor element will not be subjected to radiation damage. This is because the penetration depth of the ion beam is small; 0.1 µm or less.

(c3) Since the damage range is narrow, it is possible to perform extremely localized work. Therefore, it is unnecessary to execute the passivation step after disconnecting an interconnection.

(c4) By detecting the secondary ions of a workpiece material scattered by the irradiation of a focused ion beam, a degree of progress of the etching can be detected. Thus, the completion of the etching can be easily detected.

(c5) Since the micro-region can be disconnected it is possible to provide a number of switches which constitute a redundancy circuit on a chip. This accordingly increases the integration density. In addition, it is possible to form a device with many functions.

(c6) Even when an interconnection is covered by an insulative material, the use of a focused ion beam makes the correct positioning possible. This is because, when the focused ion beam is used, charge-up of the insulating material will not result.

Other objects and advantages will be apparent from the following description taken in conjunction with the accompanying drawings, in which:

Fig. 1 shows a schematic construction of an apparatus for disconnecting an interconnection (fuse) which is used in an embodiment of the present invention;

Fig. 2 is a flow chart for explaining interconnection disconnecting steps using the above apparatus;

Fig. 3 is a diagram for explaining the registration operation;

Fig. 4 is a plan view of a structure of an interconnection (fuse);

Fig. 5 is a cross sectional view taken along the line V—V of Fig. 4; and

Fig. 6 is a flow chart to describe a second embodiment of the present invention.

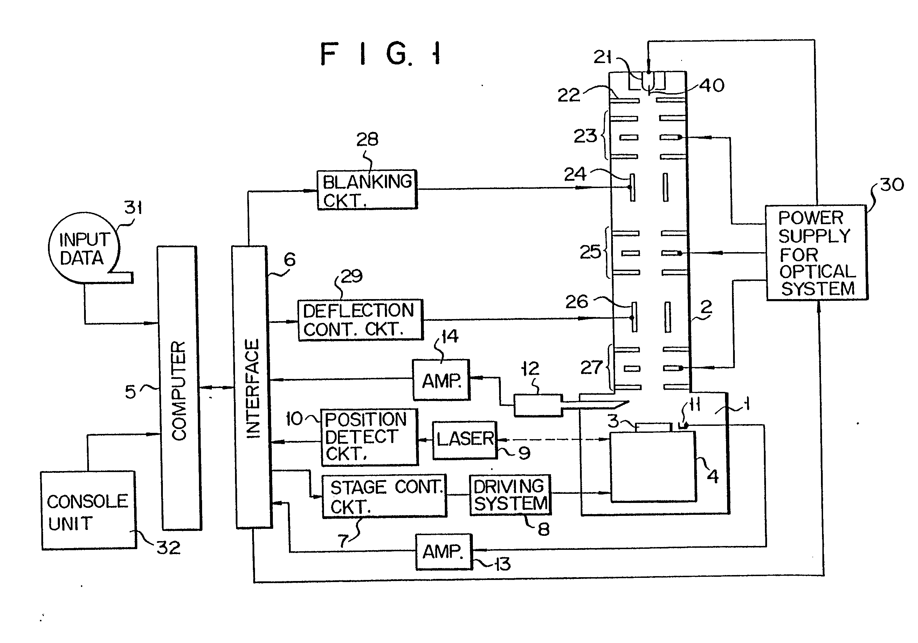

Fig. 1 shows an interconnection disconnecting apparatus which is used to implement a method of the present invention. An ion-beam optical system 2 is mounted over a workpiece chamber 1. An X—Y table 4 for fixedly holding a workpiece 3, for example, semiconductor wafer, is disposed in the workpiece chamber 1. This X—Y table 4 is moved in the X direction and in the Y direction by means of a driving system 8 to be controlled by a table control circuit 7. Commands from computer 5 are input through an interface 6 to the table control circuit 7. The position of the X—Y table 4 is detected by a laser interferometric measuring system 9 and a position detecting circuit 10. This table position data is transmitted through the interface 6 to the computer 5. A Faraday cup 11 is mounted on the X—Y stage 4 and a reflected ion detector 12 is further disposed in the upper portion in the workpiece chamber 1. Output signals of the Faraday cup 11 and reflected ion detector 12 are transmitted to the computer 5 through amplifiers 13 and 14, respectively.

The ion beam optical system 2 is constructed as follows. The ion beam optical system 2 comprises an ion gun 21, ion extracting electrodes 22; an electrostatic lens of the Einzel type, i.e., first condenser lens 23; blanking electrodes 24; an electrostatic lens; i.e., second condensor lens 25; beam-scanning deflecting electrodes 26; and an electrostatic lens, i.e., objective lens 27. The blanking electrodes 24 are connected to a blanking circuit 28 controlled by computer 5, while the deflecting electrodes 26 are connected to a deflection control circuit 29 controlled by computer 5. The ion gun 21, first condenser lens 23, second condenser lens 25, and objective lens 27 are supplied with voltages from a power supply 30. An input data source 31 is applied to the computer 5. The interconnection disconnecting apparatus is operated by a console unit 32.

The ion gun 21 has an electrode stylus 40 having a diameter of about 2 Å to which a positive high voltage is applied. The electrode stylus 40 is cooled by liquid helium. Hydrogen or argon gas is sent from the sides of the electrode stylus 40 to allow $H^+$ or $Ar^+$ ions to be generated. These $H^+$ or $Ar^+$ ions are sent to the first condenser lens 23 by the extraction electrodes 22 to which a negative voltage is applied. An accelerating voltage of the ion gun 21 is 10—50 keV; an ion beam diameter is 0.1—1 µm; and an ion beam current is about 1 nA. If the ion gun 21 is constituted by a liquid metal ion source, an ion source with high brightness can be generated. The configuration of this apparatus is substantially identical to that disclosed in U.S.

Patent Application Serial No. 411,044, filed August 24, 1982, excluding the ion generating source.

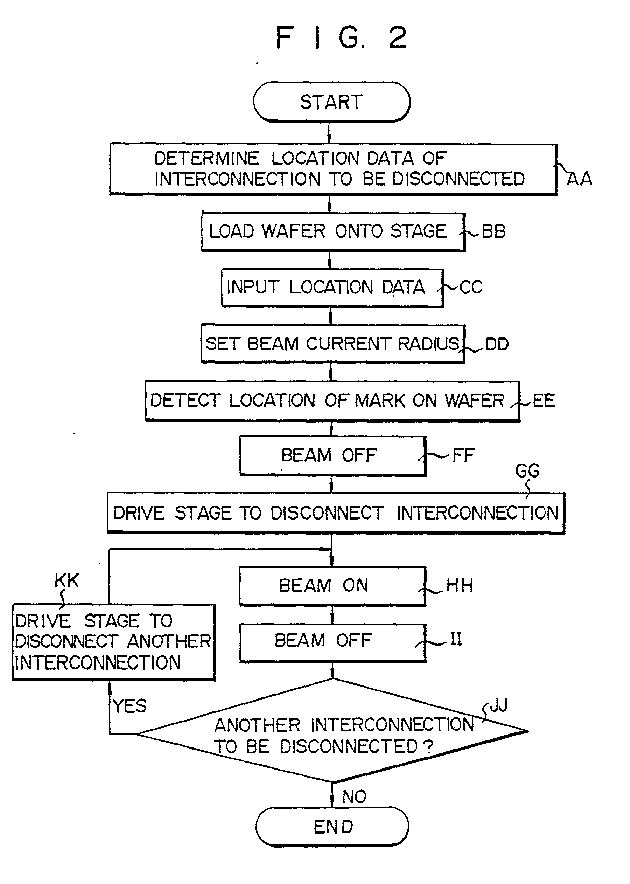

The method of disconnecting an interconnection using the above apparatus will be described with reference to a flow chart shown in Fig. 2. As shown in step AA, a defect portion of the semiconductor wafer or substrate 3 is detected using a well-known tester to obtain position data. An interconnection provided on the semiconductor wafer 3 to connect the semiconductor elements formed on the semiconductor wafer 3 is determined using this data. Then, the position data (m, n, x) of this interconnection is obtained and recorded on, for example, magnetic tape 31. m, n denote a chip located at the m-th row and n-th column of the water, while x represents the x-th interconnection of this chip. Next, the wafer 3 is loaded onto the X—Y table 4 in the workpiece chamber 1 in step BB. Thereafter, in step CC, the location data (m, n, x) indicative of the interconnection to be disconnected is input into the computer 5. In step DD, the beam current is set using the Faraday cup 11 and the beam diameter is set by adjusting the magnification of the lens.

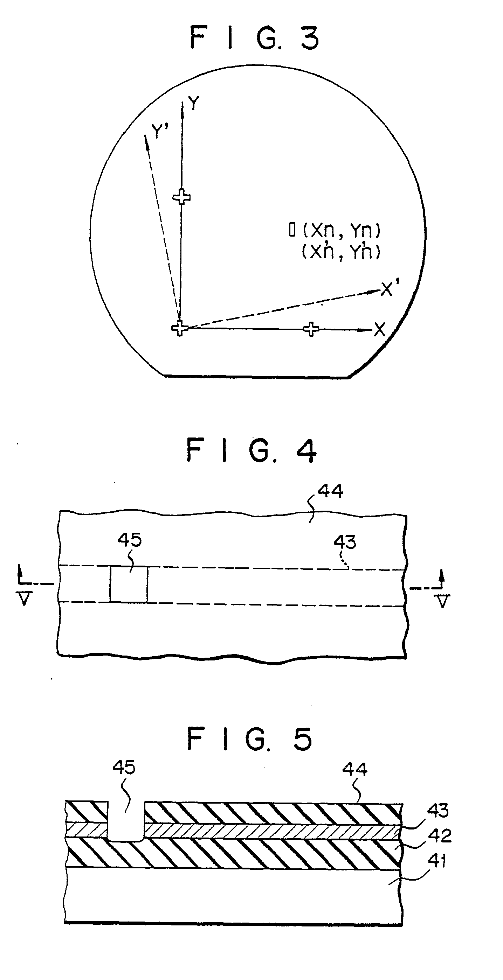

In step EE, the locations of three marks disposed on the semiconductor wafer 3 are measured using a registration technique which is well-known in the field of electron beam patterning technology. The locations $(X_i, Y_i)$ (i=1, 2, 3) of these three marks have been determined, for instance, as shown in Fig. 3. The location of interconnection is determined by the X—Y coordinate system determined on the basis of the locations of the three marks. Therefore, by detecting the reflected ions reflected from the marks due to ion beam irradiation by the reflected ion detector 12 and by measuring the locations of the three marks by the laser interferometric measuring system 9, the laser coordinate system as shown in Fig. 3, i.e., X'—Y' coordinate system, is determined. Therefore, the location of interconnection is converted from the X—Y coordinate system to the X'—Y' coordinate system, so that the relative locational relationship between the portion of the interconnection to be disconnected and the foregoing ion beam source is determined. When executing the registration and setting the beam current (beam diameter), the ion beam strength is made weak enough not to damage the wafer 3.

Subsequently, the ion beam is turned off by the blanking electrodes 24 (step FF), and the X—Y table 4 is moved to the location $(m_1, n_1, x_1)$ of the first interconnection to be disconnected (step GG). The location to which the X—Y table 4 has moved measured by the laser interferrometric measuring system, and the difference between the interconnection location to be disconnected and the beam irradiating position is fed back to the deflection control circuit 29. Due to this, the deviation amount of each of the above locations is corrected. Thereafter, the ion beam is turned on to disconnect the interconnection (step HH). An algorithm has been previously prepared in the computer 5, by which the beam irradiation time or beam scanning speed and number of scanning times can be obtained from the number of layers of workpiece, material and thickness of each layer, beam current, beam diameter, and working area. Since an ordinarily used beam diameter is 0.5 µmφ and the disconnected portion is about 3 µm in width and about 3 µm in length, the interconnection is disconnected by 1 to 100 scanning times of ion beam. Under a particular condition, an ion beam of large diameter is used which is fixed for the order of milliseconds to disconnect the interconnection. After disconnecting the interconnection by selecting one of the above two disconnecting modes, the ion beam is again turned off (step II).

Next, it is checked as to whether there is another interconnection to be disconnected or not (step JJ), and if there is such interconnection, the X—Y table 4 is driven to the next disconnecting portion (step KK), then the processing is returned to the step HH. In the case where there is not another portion to be disconnected, namely, in the case where all the portions of interconnections to be disconnected have been completely disconnected, the processing of the wafer 3 is finished.

The interconnection is constituted as shown in Figs. 4 and 5. A $SiO_2$ film 42 is formed on a silicon substrate 41 and an interconnection layer 43 consisting of Al is formed on the $SiO_2$ film 42. A passivation film 44 is formed on the interconnection layer 43. The passivation film 44 and interconnection layer 43 are etched by ion beam sputtering to form a hole 45. In this embodiment, an ion beam is irradiated over the passivation film 44, thereby disconnecting the interconnection 43. At this time, as is obvious from Figs. 4 and 5, it is unnecessary to perform the passivation again since no hole is formed in the periphery of the disconnecting portion of the interconnection 43.

Furthermore, even if a focused ion beam is irradiated onto the passivation film 44 to obtain position data of the interconnection to be disconnected or to disconnect the interconnection 43 the semiconductor element will not be subjected to radiation damage. This is because the penetration depth of the ion beam is 0.1 µm or less.

Since the interconnection 43 is disconnected by the etching due to sputtering or bombardment, it is possible to disconnect the region which is substantially equal to the ion beam diameter. Since the ion beam diameter can be set to approximately 0.1 µm, the region with a diameter of 0.1 µm can be disconnected. Therefore, it is possible to provide a number of interconnection portions to be disconnected, i.e., switches on one chip, so that this contributes to an increase in integration density. Thus, a multi-function device can be formed.

Even if the location of the interconnection 43 covered by the passivation film 44 is detected by a focused ion beam, no charge-up will be caused in the passivation film 44; therefore, it is possible to perform a correct detection.

Moreover, different from the method using a laser beam, since a focused ion beam is not reflected from the metal interconnection 43, any kind of metal can be easily disconnected.

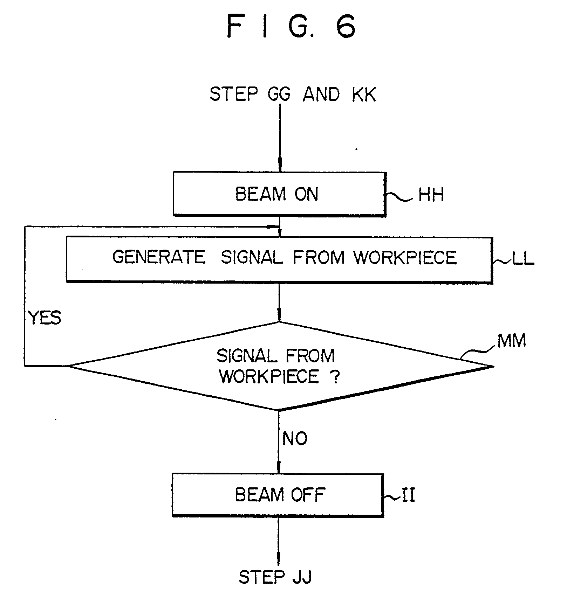

A second embodiment of the present invention will now be described with reference to Fig. 6. The difference between this method and the first embodiment is that there are further provided, after beam ON, step LL for allowing a signal from a workpiece to be generated, and step MM for checking the etching state by detecting the signal from the workpiece. If the signal from the workpiece is detected, the beam will be continuously kept on. When the signal from the workpiece disappears, the beam irradiation is stopped. The signal from the workpiece is analyzed by a secondary ion mass analyzer and Auger electron analyzer. In these analyzers, the materials scattered from the workpiece by irradiation of ion beam are detected. The other steps are the same as those of the first embodiment. According to this second embodiment, since the degree of etching progress can be detected the etching completion can be easily detected.

The present invention is not limited to the foregoing embodiments. Many variations and modifications of the invention are possible without departing from the scope of the invention as defined in the claims. As an apparatus for embodying the present invention, it is not limited to the apparatus with the constitution shown in Fig. 1. Any apparatus may be used if it has as its function to both produce a focused ion beam and align the relative location between the interconnection portion to be disconnected and the beam irradiating location.

**Claims**

1. A method of disconnecting an interconnection using a focused ion beam comprising the steps of:—

(A) aligning a portion to be disconnected of an interconnection (43) formed on a semiconductor substrate (41) to connect semiconductor elements formed in the substrate with an ion beam irradiating location, by irradiating the focused ion beam onto an insulating film provided over the semiconductor substrate and the interconnection and determining a location of the portion of the interconnection;

(B) irradiating a focused ion beam generated from a focused ion beam source onto the insulating film and the portion of the interconnection to etch the insulating film and the portion of interconnection by sputtering, thereby disconnecting the interconnection.

2. A method according to claim 1, characterised in that the step of determining the location of the portion of the interconnection includes obtaining location data of the portion to be disconnected.

3. A method according to claim 2, characterised in that the location data is determined by virtue of the step of irradiating the focused ion beam onto the insulating film.

4. A method according to claim 3, characterised in that the insulating film is a passivation film.

5. A method according to claim 1, characterised in that the step (A) includes the steps of:

(a11) obtaining the location data of the interconnection to be disconnected on the semiconductor substrate by using a tester;

(a12) loading the semiconductor substrate onto a table of a focused ion beam apparatus;

(a13) detecting locations of reference marks on the semiconductor substrate using the focused ion beam to determine the relative locational relationship between the focused ion beam and the semiconductor substrate; and

(a14) moving the table according to the location data of the interconnection to be disconnected to align the portion to be disconnected with the ion beam irradiating location.

6. A method according to claim 1, characterised in that

in the step (B), the interconnection is covered by an insulating film, and the focused ion beam is irradiated from over the insulating film.

7. A method according to claim 6, characterized in that

the insulating film is a passivation film.

8. A method according to claim 1, characterized in that

the interconnection etching state is detected in a step (C) by identifying the particles scattered due to the irradiation of the focused ion beam during disconnection of the interconnection, and that the focused ion beam is turned off after confirming the state in which scattering of the particles no longer occur.

9. A method according to claim 8, characterized in that

the step (C) is executed by a secondary ion mass analyzer.

10. A method according to claim 8, characterized in that

the step (C) is executed by an Auger electron analyzer.

**Patentansprüche**

1. Verfahren zum Trennen von Verbindungen durch Benutzen eines fokussierten Ionen(strahlen)bündels, umfassend die folgenden Schritte:

(A) Ausrichten eines zu trennenden Abschnitts einer Verbindung (43), die auf einem Halbleitersubstrat (41) zum Verbinden von im Substrat erzeugten Halbleiterelementen ausgebildet ist, mit einer Ionenbündel-Bestrahlungsstelle durch Aufstrahlen des fokussierten Ionenbündels auf einen über dem Halbleitersubstrat und der Verbindung vorgesehenen Isolierfilm und Bestimmen einer Lage des Abschnitts der Verbindung, (sowie)

(B) Aufstrahlen eines durch eine Strahlenquelle für fokussiertes Ionen(strahlen)bündel erzeugten fokussierten Ionenbündels auf den Isolierfilm und den Abschnitt der Verbindung zwecks Ätzens des Isolierfilms und des Abschnitts der Verbindung durch Zerstäubung, um damit die Verbindung zu trennen.

## EP 0 124 358 B1

2. Verfahren nach Anspruch 1, dadurch gekennzeichnet, daß im Schritt der Bestimmung der Lage des Abschnitts der Verbindung Lagendaten des zu trennenden Abschnitts gewonnen werden.

3. Verfahren nach Anspruch 2, dadurch gekennzeichnet, daß die Lagendaten mittels des Schritts des Aufstrahlens des fokussierten Ionen(strahlen)bündels auf den Isolierfilm bestimmt werden.

4. Verfahren nach Anspruch 3, dadurch gekennzeichnet, daß der Isolierfilm ein Passivierfilm ist.

5. Verfahren nach Anspruch 1, dadurch gekennzeichnet, daß der Schritt (A) die folgenden Schritte umfaßt:

(a11) Gewinnung (oder Ermittlung) der Lagendaten der zu trennenden Verbindung auf dem Halbleitersubstrat unter Verwendung eines Test- oder Prüfgeräts,

(a12) Auflegen des Halbleitersubstrats auf einen Tisch eines Geräts für fokussiertes Ionenbündel,

(a13) Detektieren von Lagen von Bezugsmarken auf dem Halbleitersubstrat mittels des fokussierten Ionen(strahlen)bündels zwecks Bestimmung der relativen Lagenbeziehung zwischen dem fokussierten Ionenbündel und dem Halbleitersubstrat sowie

(a14) Verschieben des Tisches entsprechend den Lagendaten der zu trennenden Verbindung zwecks Ausrichtung des zu trennenden Abschnitts auf die Ionenbündel-Bestrahlungsstelle.

6. Verfahren nach Anspruch 1, dadurch gekennzeichnet, daß im Schritt (B) die Verbindung durch einen Isolierfilm abgedeckt ist oder wird und das fokussierte Ionenbündel von oberhalb des Isolierfilms aufgestrahlt wird.

7. Verfahren nach Anspruch 6, dadurch gekennzeichnet, daß der Isolierfilm ein Passivierfilm ist.

8. Verfahren nach Anspruch 1, dadurch gekennzeichnet, daß

der Verbindungs-Ätzzustand in einem Schritt (C) durch Identifizierung der aufgrund der Aufstrahlung des fokussierten Ionenbündels während der Trennung der Verbindung gestreuten Teilchen detektiert bzw. festgestellt wird und daß das fokussierte Ionenbündel nach Bestätigung bzw. Feststellung des Zustands, in welchem keine Streuung von Teilchen mehr auftritt, abgeschaltet wird.

9. Verfahren nach Anspruch 8, dadurch gekennzeichnet, daß

der Schritt (C) mittels eines Sekundärionen-Massenanalysators durchgeführt wird.

10. Verfahren nach Anspruch 8, dadurch gekennzeichnet, daß

der Schritt (C) mittels eines Auger-Elektronenanalysators durchgeführt wird.

## Revendications

1. Un procédé de déconnexion d'une interconnexion utilisant un faisceau d'ions focalisé comprenant les étapes suivantes:

(A) on aligne avec une position de projection d'un faisceau d'ions, une partie à déconnecter d'une interconnexion (43) qui est formée sur un substrat semiconducteur (41) pour connecter des éléments semiconducteurs qui sont formés dans le substrat, en projetant le faisceau d'ions focalisé sur une couche isolante qui est formée sur le substrat semiconducteur et sur l'interconnexion, et en déterminant la position de la partie précitée de l'interconnexion;

(B) on projette sur la couche isolante et sur la partie précitée de l'interconnexion un faisceau d'ions focalisé qui est produit par une source de faisceau d'ions focalisé, pour attaquer la couche isolante et la partie précitée de l'interconnexion, par pulvérisation cathodique, afin de déconnecter l'interconnexion.

2. Un procédé selon la revendication 1, caractérisé en ce que l'étape de détermination de la position de la partie précitée de l'interconnexion comprend l'obtention de données de position de la partie à déconnecter.

3. Un procédé selon la revendication 2, caractérisé en ce qu'on détermine les données de position sur la base de l'étape consistant à projeter le faisceau d'ions focalisé sur la couche isolante.

4. Un procédé selon la revendication 3, caractérisé en ce que la couche isolante est une couche de passivation.

5. Un procédé selon la revendication 1, caractérisé en ce que l'étape (A) comprend les étapes suivantes:

(a11) on détermine au moyen d'un dispositif de test les données de position de l'interconnexion à déconnecter sur le substrat semiconducteur;

(a12) on charge le substrat semiconducteur sur un plateau d'un appareil à faisceau d'ions focalisé;

(a13) on détecte des positions de marques de référence sur le substrat semiconducteur, en utilisant le faisceau d'ions focalisé pour déterminer la relation de position entre le faisceau d'ions focalisé et le substrat semiconducteur; et

(a14) on déplace le plateau conformément aux données de position de l'interconnexion à déconnecter, pour aligner la partie à déconnecter avec la position de projection du faisceau d'ions.

6. Un procédé selon la revendication 1, caractérisé en ce que

dans l'étape (B), l'interconnexion est recouverte par une couche isolante, et le faisceau d'ions focalisé est projeté à partir d'une position située au-dessus de la couche isolante.

7. Un procédé selon la revendication 6, caractérisé en ce que

la couche isolante est une couche de passivation.

8. Un procédé selon la revendication 1, caractérisé en ce que

dans une étape (C), on détecte l'état d'attaque de l'interconnexion, en identifiant les particules qui sont diffuséses sous l'effet de la projection du faisceau d'ions focalisé, pendant la déconnexion de l'interconnexion, et en ce qu'on interrompt le faisceau d'ions focalisé après avoir vérifié l'existence de l'état dans lequel la diffusion des particules ne se produit plus.

9. Un procédé selon la revendication 8, caractérisé en ce que

l'étape (C) est accomplie au moyen d'un analyseur de masse d'ions secondaires.

10. Un procédé selon la revendication 8, caractérisé en ce que

l'étape (C) est accomplie au moyen d'un analyseur d'électrons Auger.

F I G. 1

EP 0 124 358 B1

# F I G. 2

```
                    ┌─────────┐
                    │  START  │
                    └─────────┘
                         │
    ┌────────────────────────────────────────┐
    │  DETERMINE LOCATION DATA OF             │ AA
    │  INTERCONNECTION TO BE DISCONNECTED     │
    └────────────────────────────────────────┘
                         │
         ┌──────────────────────────────┐
         │  LOAD WAFER ONTO STAGE       │ BB
         └──────────────────────────────┘
                         │
           ┌──────────────────────────┐
           │  INPUT LOCATION DATA     │ CC
           └──────────────────────────┘
                         │
         ┌──────────────────────────────┐
         │  SET BEAM CURRENT RADIUS     │ DD
         └──────────────────────────────┘
                         │
      ┌────────────────────────────────────┐
      │  DETECT LOCATION OF MARK ON WAFER  │ EE
      └────────────────────────────────────┘
                         │
            ┌──────────────────────┐
            │     BEAM  OFF        │ FF
            └──────────────────────┘
                         │                          GG
    ┌────────────────────────────────────────────┐
    │  DRIVE STAGE TO DISCONNECT  INTERCONNECTION │
    └────────────────────────────────────────────┘
                         │
          ┌──────────────┤
          │              │
    KK    │     ┌──────────────────────┐
          │     │      BEAM  ON        │ HH
          │     └──────────────────────┘
 ┌─────────────────┐     │
 │ DRIVE  STAGE TO │     │
 │ DISCONNECT ANOTHER│   ┌──────────────────────┐
 │ INTERCONNECTION │     │     BEAM  OFF        │ II
 └─────────────────┘     └──────────────────────┘
          │              │
        YES              │                         JJ
          │        ┌────────────────────────────┐
          └────────│  ANOTHER INTERCONNECTION   │
                    │  TO BE DISCONNECTED ?      │
                    └────────────────────────────┘
                               │ NO
                         ┌─────────┐
                         │   END   │
                         └─────────┘
```

# F I G. 3

$\square$ (Xn, Yn)
(Xṅ, Yṅ)

# F I G. 4

44

45

43

# F I G. 5

45

44

43
42
41

# F I G. 6

STEP GG AND KK

```
        ┌─────────────────────────┐
        │         BEAM ON          │ ～HH
        └─────────────────────────┘
  ┌──────────────────────────────────────────────┐
  │     GENERATE  SIGNAL FROM WORKPIECE           │ ～LL
  └──────────────────────────────────────────────┘
  YES

         ◇ SIGNAL FROM              ～MM
           WORKPIECE ?

              NO
        ┌─────────────────────────┐
        │        BEAM OFF          │ ～II
        └─────────────────────────┘

              STEP JJ
```